# EUROPEAN PATENT SPECIFICATION

(11) **EP 3 792 790 B1**
(45) Date of publication and mention of the grant of the patent: **02.07.2025**
(21) Application number: 18918140.7
(22) Date of filing: 28.12.2018
(51) Int. Cl.: G06F 30/367, H01Q 21/29, H01Q 21/00, H04B 7/06

(54) **RADIATION PATTERN CALCULATION METHOD AND DEVICE FOR BEAM-POINTING ADJUSTABLE ANTENNA**
STRAHLUNGSMUSTERBERECHNUNGSVERFAHREN UND VORRICHTUNG FÜR EINE EINSTELLBARE STRAHLRICHTANTENNE
PROCÉDÉ ET DISPOSITIF DE CALCUL DE DIAGRAMME DE RAYONNEMENT POUR ANTENNE RÉGLABLE DE POINTAGE DE FAISCEAU

(30) Priority: 08.05.2018 CN 201810431836
(43) Date of publication of application: 17.03.2021
(73) Proprietor: Kuang-Chi Institute of Advanced Technology, Shenzhen, Guangdong 518057 (CN)
(72) Inventor: LIU, RuoPeng, shenzhen, Guangdong 518057 (CN); ZHAO, Zhi Ya, shenzhen, Guangdong 518057 (CN); TIAN, Hua, shenzhen, Guangdong 518057 (CN); DING, Yi, shenzhen, Guangdong 518057 (CN)
(74) Representative: Goddar, Heinz J.
(86) International application number: PCT/CN2018/124555
(87) International publication number: WO 2019/214256

(56) References cited:
- CN-A- 102 411 676
- CN-A- 103 412 970
- CN-A- 105 467 365
- US-A1- 2003 016 180
- GRBIC A ET AL: "LEAKY CPW-BASED SLOT ANTENNA ARRAYS FOR MILLIMETER-WAVE APPLICATIONS", IEEE TRANSACTIONS ON ANTENNAS AND PROPAGATION, IEEE, USA, vol. 50, no. 11, 1 November 2002 (2002-11-01), pages 1494 - 1504, XP001141990, ISSN: 0018-926X, DOI: 10.1109/TAP.2002.804259
- CHRISTOPHE CALOZ ET AL: "CRLH metamaterial leaky-wave and resonant antennas", IEEE ANTENNAS AND PROPAGATION MAGAZINE, IEEE SERVICE CENTER, PISCATAWAY, NJ, US, vol. 50, no. 5, 1 October 2008 (2008-10-01), pages 25 - 39, XP011238192, ISSN: 1045-9243, DOI: 10.1109/MAP.2008.4674709
- MAJID HUDA A ET AL: "Frequency and Pattern Reconfigurable Slot Antenna", IEEE TRANSACTIONS ON ANTENNAS AND PROPAGATION, IEEE, USA, vol. 62, no. 10, 1 October 2014 (2014-10-01), pages 5339 - 5343, XP011560543, ISSN: 0018-926X, [retrieved on 20141002], DOI: 10.1109/TAP.2014.2342237
- NGUYEN-TRONG NGHIA ET AL: "Transmission-Line Model of Nonuniform Leaky-Wave Antennas", IEEE TRANSACTIONS ON ANTENNAS AND PROPAGATION, IEEE, USA, vol. 64, no. 3, 1 March 2016 (2016-03-01), pages 883 - 893, XP011608872, ISSN: 0018-926X, [retrieved on 20160301], DOI: 10.1109/TAP.2016.2517669
- CHENG JIN ET AL: "Leaky-Wave Radiation Behavior From a Double Periodic Composite Right/Left-Handed Substrate Integrated Waveguide", IEEE TRANSACTIONS ON ANTENNAS AND PROPAGATION, IEEE, USA, vol. 60, no. 4, 1 April 2012 (2012-04-01), pages 1727 - 1735, XP011460982, ISSN: 0018-926X, DOI: 10.1109/TAP.2012.2186248

## Description

### TECHNICAL FIELD

The present disclosure relates to the technical field of antenna, and specifically, to a method and device for calculating directional pattern of a beam pointing adjustable antenna.

### BACKGROUND

A waveguide-based beam pointing adjustable antenna (leaky-wave antenna) has advantages of low costs, long life, low profile, full shielding to eliminate complex internal scattering. Key factors for designing the beam pointing adjustable antenna includes: slot unit, slot spacing, slot arrangement, slot on and off control, etc. Among them, in order to achieve precise regulation of specific beam directions and low side-lobe control in a working frequency band, linkage optimization of the above-mentioned key factors is required.

A conventional design method for a beam pointing adjustable antenna having regular slots is relatively mature, factors such as slot size and spacing are related to directional pattern formed by the antenna, and the form is relatively intuitive. However, it does not have turning-on or cutting-off function, and cannot achieve beam pointing deflection.

A design method for a beam pointing adjustable antenna having irregular slots greatly depends on simulation software, global optimization takes a relatively long time, which is difficult for engineering applications.

For a beam-adjustable system, the principle of phased arrays is usually used for reference, and the array elements are the same. However, the beam control of the system is implemented through precise phase modulation of each array element. Compared with the beam pointing adjustable antenna having a plurality of slot units, the control mechanism is different. For the beam pointing adjustable antenna, it is difficult to provide guidance for turning-on or cutting-off each slot unit.

For the prior-art problems that beam pointing and deflection cannot be achieved, dependency on the simulation software is large, and it is difficult to provide guidance for turning-on or cutting-off each slot unit according to the phased array principle, no effective solution have been proposed.

Documents GRBIC A ET AL: "LEAKY CPW-BASED SLOT ANTENNA ARRAYS FOR MILLIMETER-WAVE APPLICATION", IEEE, USA, 2002-11-01, XPOO1141990; CHRISTOPHE CALOZ ET AL: "CRLH metamaterial leaky-wave and resonant antennas", IEEE ANTENNAS AND PROPAGATION MAGAZINE, IEEE SERVICE CENTER, PISCATAWAY, Nu, US, vol. 50, no. 5, 1 October 2008 (2008-10-01), XP011238192; MAJID HUDA A ET AL: "Frequency and Pattern Reconfigurable Slot Antenna", IEEE TRANSACTIONS ON ANTENNAS AND PROPAGATION, IEEE, USA, vol. 62, no. 10, 1 October 2014 (2014-10-01), pages 5339-5343, XP011560543; NGUYEN-TRONG NGHIA ET AL: "Transmission-Line Model of Nonuniform Leaky-Wave Antennas", IEEE TRANSACTIONS ON ANTENNAS AND PROPAGATION, IEEE, USA, vol. 64, no. 3, 1 March 2016, pages 883-893, XP011608872; CHENG JIN ET AL: "Leaky-Wave Radiation Behavior From a Double Periodic Composite Right/Left-Handed Substrate Integrated Waveguide", IEEE TRANSACTIONS ON ANTENNAS AND PROPAGATION, IEEE, USA, vol. 60, no. 4, 1 April 2012 (2012-04-01), pages 1727-1735, XP011460982; and Patent document US 2003/016180 A1 provide related technical solutions; however, the above mentioned problem still remains unsolved.

### SUMMARY

For the prior-art problems that beam pointing and deflection cannot be achieved, dependency on the simulation software is large, and it is difficult to provide guidance for turning-on or cutting-off each slot unit according to the phased array principle, the present disclosure provides a method and device for calculating directional pattern of a beam pointing adjustable antenna, which can realize the weighted calculation of directional pattern of the beam pointing adjustable antenna without depending on simulation software, at the same time, various key parameters can be globally optimized, so as to realize the fast beam switching.

The present invention is defined by the appended claims.

The technical solutions in the present disclosure are implemented as follows:
According to one aspect of the present disclosure, a method for calculating directional pattern of a beam pointing adjustable antenna is provided, the beam pointing adjustable antenna comprises a plurality of slot units, the method comprises the following steps:
S1. obtaining a scattering parameter matrix of a single-slot waveguide corresponding to a single slot unit and a transmission matrix of a seamless waveguide through measurement, and obtaining an equivalent transmission matrix of the single slot unit according to the scattering parameter matrix of the single-slot waveguide and the transmission matrix of the seamless waveguide;
S2. obtaining an arrangement and combination mode of the slot units and a beam pointing control code representing on or off state of each slot unit, and obtaining a transmission matrix cascading mode of the beam pointing adjustable antenna according to the arrangement and combination mode, the beam pointing control code, and an equivalent scattering parameter matrix of the single slot unit; and
S3. obtaining the directional pattern of the single-slot waveguide excited at the left end and the directional pattern of the single-slot waveguide excited at the right end, and obtaining a composite directional pattern of the beam pointing adjustable antenna according to the directional pattern of the single-slot waveguide excited at the left end, the directional pattern of the single-slot waveguide excited at the right end, and the transmission matrix cascading mode of the beam pointing adjustable antenna.

According to another aspect of the present disclosure, a device for calculating directional pattern of the beam pointing adjustable antenna is provided, the device comprises:
a slot transmission matrix obtaining module configured for: obtaining a scattering parameter matrix of a single-slot waveguide corresponding to a single slot unit and a transmission matrix of a seamless waveguide through measurement, and obtaining an equivalent transmission matrix of the single slot unit according to a total transmission matrix of the single-slot waveguide and the transmission matrix of the seamless waveguide;
an antenna transmission matrix obtaining module configured for: obtaining an arrangement and combination mode of the slot units and a beam pointing control code representing on or off state of each slot unit, and obtaining a transmission matrix cascading mode of the beam pointing adjustable antenna according to the arrangement and combination mode, the beam pointing control code, and an equivalent scattering parameter matrix of the single slot unit; and
an antenna directional pattern generating module configured for: obtaining the directional pattern of the single-slot waveguide excited at the left end and the directional pattern of the single-slot waveguide excited at the right end, and obtaining a composite directional pattern of the beam pointing adjustable antenna according to the directional pattern of the single-slot waveguide excited at the left end, the directional pattern of the single-slot waveguide excited at the right end, and the transmission matrix cascading mode of the beam pointing adjustable antenna.

In the present disclosure, the scattering parameter of the single slot unit is obtained through direct measurement, therefore, operability is strong or high, and directional pattern of the beam pointing adjustable antenna is calculated without depending on simulation software. In addition, the weighted calculation of directional pattern of the beam pointing adjustable antenna is realized. Key information including a form of the slot unit and arrangement and combination mode of the slot units can be globally optimized. Which greatly saves the optimization of slot unit selection, arrangement, combination, and spacing during antenna design, so as to focus on structural form of the slot unit. In addition, according to the beam pointing and deflection requirement, the corresponding beam pointing control codes for on and off states of each slot unit may be further calculated, so as to provide guidance for the regulation of the beam pointing and achieve fast beam shaping and switching.

### BRIEF DESCRIPTION OF DRAWINGS

To describe the technical solutions in the embodiments of the present disclosure or in the prior art more clearly, the following briefly describes the accompanying drawings required for describing the embodiments. Apparently, the accompanying drawings in the following description show merely some embodiments of the present disclosure, and a person of ordinary skill in the art may still derive other drawings from these accompanying drawings without creative efforts.
FIG. 1 is a flowchart of a directional pattern calculation method for a beam pointing adjustable antenna according to an embodiment of the present disclosure;
FIG. 2 is a flowchart of a directional pattern calculation method for a beam pointing adjustable antenna according to a specific embodiment of the present disclosure; and
FIG. 3 is a block diagram of a directional pattern calculation apparatus for a beam pointing adjustable antenna according to an embodiment of the present disclosure.

### DESCRIPTION OF EMBODIMENTS

The following clearly and completely describes the technical solutions in the embodiments of the present disclosure with reference to the accompanying drawings in the embodiments of the present disclosure. Apparently, the described embodiments are merely some but not all of the embodiments of the present disclosure. All other embodiments obtained by a person of ordinary skill in the art according to the embodiments of the present disclosure shall fall within the protection scope of the present disclosure.

According to an embodiment of the present disclosure, a directional pattern calculation method for a beam pointing adjustable antenna is provided. Usually, the beam pointing adjustable antenna is also referred to as a leaky-wave antenna, and includes a plurality of slots that generate leaky waves.

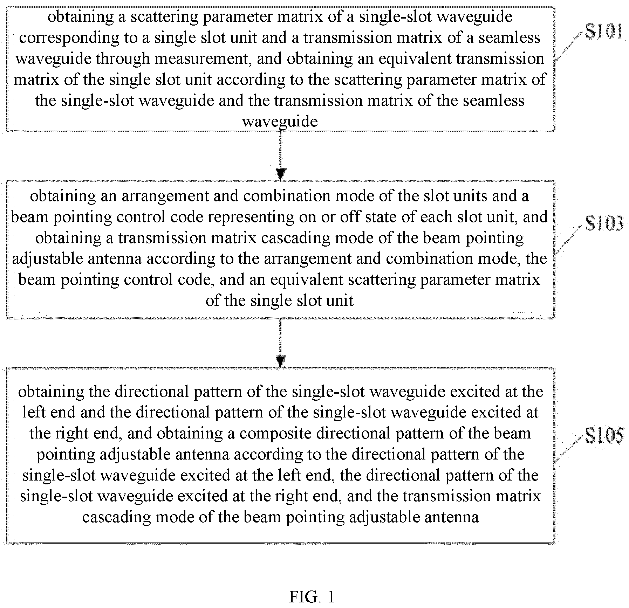

As shown in FIG. 1, a method for calculating directional pattern of a beam pointing adjustable antenna according to an embodiment of the present disclosure includes the following steps:
S101. obtaining a scattering parameter matrix of a single-slot waveguide corresponding to a single slot unit and a transmission matrix of a seamless waveguide through measurement, and obtaining an equivalent transmission matrix of the single slot unit according to the scattering parameter matrix of the single-slot waveguide and the transmission matrix of the seamless waveguide.
S103. obtaining an arrangement and combination mode of the slot units and a beam pointing control code representing on or off state of each slot unit, and obtaining a transmission matrix cascading mode of the beam pointing adjustable antenna according to the arrangement and combination mode, the beam pointing control code, and an equivalent scattering parameter matrix of the single slot unit.
S105. obtaining the directional pattern of the single-slot waveguide excited at the left end and the directional pattern of the single-slot waveguide excited at the right end, and obtaining a composite directional pattern of the beam pointing adjustable antenna according to the directional pattern of the single-slot waveguide excited at the left end, the directional pattern of the single-slot waveguide excited at the right end, and the transmission matrix cascading mode of the beam pointing adjustable antenna.

Furthermore, various electrical performance indicators of the array antenna can be evaluated, such as: beam pointing angle, main lobe 3dB beam width, a first null width, a side lobe level, a front-to-rear ratio, etc.

The above technical solution of the present disclosure quantifies key control factors such as the arrangement and combination of multiple slot units, the slot unit spacing, and the wave control coding of the on and off states of the slot units, and evaluates the array antennas with different slot unit combinations and adjustments. The far-field pattern can be used to evaluate the electrical performance indicators of the array antenna; the weighted calculation of the beam pointing adjustable antenna pattern is realized; the key information including the slot unit form, the combination and arrangement of the slot unit can be performed Global optimization greatly saves the optimization of slot unit selection, arrangement, combination, and spacing in antenna design, so as to focus on the design of the slot unit structure; in addition, it can also calculate the corresponding slot unit according to the beam pointing and deflection requirements The wave control coding of the on and off states provides guidance for the adjustment of the beam pointing to achieve rapid beam shaping and switching.

In the present disclosure, the scattering parameter of the single slot unit is obtained through direct measurement, therefore, operability is strong or high, and directional pattern of the beam pointing adjustable antenna is calculated without depending on simulation software. In addition, the weighted calculation of directional pattern of the beam pointing adjustable antenna is realized. Key information including a form of the slot unit and arrangement and combination mode of the slot units can be globally optimized. Which greatly saves the optimization of slot unit selection, arrangement, combination, and spacing during antenna design, so as to focus on structural form of the slot unit. In addition, according to the beam pointing and deflection requirement, the corresponding beam pointing control codes for on and off states of each slot unit may be further calculated, so as to provide guidance for the regulation of the beam pointing and achieve fast beam shaping and switching.

In one embodiment, at step S101, obtaining the total transmission matrix of the single-slot waveguide corresponding to one slot unit may specifically include the following steps: simulating the single-slot waveguide to obtain the total scattering parameter of the single-slot waveguide; The total scattering parameter of the waveguide obtains the total transmission matrix of the single-slit waveguide.

In one embodiment, at step S101, obtaining the scattering parameter matrix of the single-slot waveguide through measurement specifically includes: obtaining the scattering parameter matrix of the single-slot waveguide by performing a two-port test on the single-slot waveguide.

In one embodiment, at step S101, obtaining the transmission matrix of the seamless waveguide specifically includes: obtaining an equivalent transmission line model of the seamless waveguide; and performing calculation according to the equivalent transmission line model of the seamless waveguide and transmission line matrix theory to obtain the transmission matrix of the seamless waveguide.

In one embodiment, at step S103, the arrangement and combination mode of the slot unit includes a spacing between the slot units, a form of the slot unit, or a combination of them.

In one embodiment, the step S105 specifically include: obtaining an equivalent input-to-output ratio of a single slot unit according to a transmission matrix of the beam pointing adjustable antenna; obtaining the directional pattern of the single-slot waveguide excited at the left end and the directional pattern of the single-slot waveguide excited at the right end; and obtaining the composite directional pattern according to the directional pattern of the single-slot waveguide excited at the left end, the directional pattern of the single-slot waveguide excited at the right end, and the equivalent input-to-output ratio of the single slot unit.

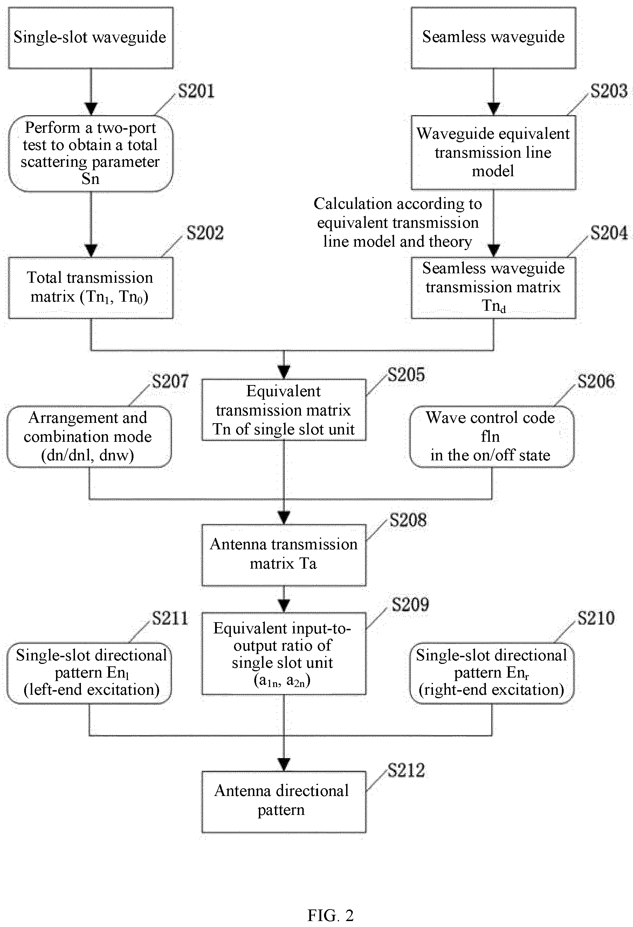

FIG. 2 shows a method for calculating directional pattern of the beam pointing adjustable antenna according to a specific embodiment of the present disclosure. Referring to FIG. 2, the method includes the following steps:
S201. Performing a two-port test on a single-slot waveguide to obtain a total scattering parameter Sn of n single-slot waveguides, wherein the total scattering parameter Sn includes a scattering parameter Sn₁ of different slot units in the on state and a scattering parameter Sn₀ of different slot units in the off state. In other words, the scattering parameter Sn=Sn₁ of different slot units in the on state and the scattering parameter Sn=Sn₀ of different slot units in the off state are measured by using the two-port test method.
S202. Obtaining the total transmission matrix of the single-slot waveguide according to the total scattering parameter Sn of the single-slot waveguide. The total transmission matrix includes transmission matrixes Tn₁ and Tn₀. Wherein, the transmission matrix Tn₁ is obtained by conversion according to the scattering parameter Sn₁ in the on state. The transmission matrix Tn₀ is obtained by conversion according to the scattering parameter Sn₀ in the off state.
S203. Obtaining an equivalent transmission line model of a seamless waveguide.
S204. Performing calculation according to the equivalent transmission line model of the seamless waveguide and transmission line matrix theory, to obtain a transmission matrix Tn_{d} of the seamless waveguide.
S205. Obtaining an equivalent transmission matrix Ts of the slot unit according to the total transmission matrixes Tn₁ and Tn₀ of the single-slot waveguide and the transmission matrix Tn_{d} of the seamless waveguide.
S206. Obtaining a beam pointing control code fln=1 indicating the on state of each slot unit or a beam pointing control code fln=0 indicating the off state of each slot unit.
S207. Obtaining arrangement and combination mode of a plurality of slot units and a spacing between slot units (denoted as dn for a one-dimensional array, and denoted as dn₁ and dn_{w} for a two-dimensional array respectively).
S208. According to the arrangement and combination mode and the beam pointing control code, simulating a transmission matrix Ta of the beam pointing adjustable antenna in the form of a transmission matrix cascading mode.
S209. Calculating the equivalent input-to-output ratio of the single slot unit according to the transmission matrix Ta of the beam pointing adjustable antenna, that is, an input ratio a₁ₙ at an input end 1 of the n^{th} slot unit in a two-port equivalent network in a single-port and unit-excitation case, and an input ratio a₂ₙ at an output end 2.
S210. Obtaining right end excitation directional pattern data Enᵣ excited at the right end of the slot unit in the on and off states through measurement. The right end excitation directional pattern data Enᵣ includes right end excitation directional pattern data Enᵣ₁ in the on state and right end excitation directional pattern data Enᵣ₀ in the off state.
S211. Obtaining left end excitation directional pattern data En₁ excited at the left end of the slot unit in the on and off states through measurement. The left end excitation directional pattern data En₁ includes left end excitation directional pattern data En₁₁ in the on state and left end excitation directional pattern data En₁₀ in the off state.
S212. Performing weighted calculation on the directional pattern of the beam pointing adjustable antenna according to the right end excitation directional pattern data, the left end excitation directional pattern data, and the equivalent input-to-output ratio of the single slot unit.

Among them, the order of steps S206 and S207 can be interchanged or performed simultaneously, and the order of steps S210 and S211 can also be interchanged or performed simultaneously.

In the directional pattern calculation method for a beam pointing adjustable antenna shown in FIG. 2, an input signal includes: the total scattering parameter Sn of the single-slot waveguides, the scattering parameter Sn_{d} of the seamless waveguide, the arrangement and combination mode of the slot units, the beam pointing control codes, the right-port-excited directional pattern data, and the left-port-excited directional pattern data; and output is the directional pattern of the beam pointing adjustable antenna. The total scattering parameter Sn of the single-slot waveguides, the right-port-excited directional pattern data, and the left-port-excited directional pattern data can be all obtained by using a direct measurement method.

In one embodiment, the beam pointing adjustable antenna is a one-dimensional or two-dimensional array structure. The directional pattern calculation method for a beam pointing adjustable antenna in the present disclosure is applicable to a plurality of combinations of slot units, is applicable to both a one-dimensional array and a two-dimensional array, and therefore has relatively high value in engineering application.

In summary, in the present disclosure, the method for calculating directional pattern of beam pointing adjustable antenna is quantized by key control factors, for example, arrangement and combination mode of n slot units, a spacing between slot units (denoted as dn for one-dimensional array, and denoted as dn₁ and dn_{w} for two-dimensional array), beam pointing control code (fln=1) for on state of the slot unit, and beam pointing control code (fln=0) for off state of the slot unit. The present disclosure evaluates far-field directional pattern of the array antenna controlled by different combination and adjustment of the slot units, and further evaluates the electrical performance indicators (for example, beam pointing angle, main-lobe beam width at 3 dB, first null width, side-lobe level, and front-to-rear ratio) of the array antenna. The scattering parameters in the on state (Sn=Sn₁) and the off state (Sn=Sn₀) of different slot units are extracted by measurement and other methods. The scattering parameter (Sn_{d}) is calculated with reference to the equivalent transmission line theory of the seamless waveguide of any length. After conversion, the transmission matrixes (Tn₁, Tn₀, and Tn_{d}) are obtained, and the equivalent transmission matrix (Tn) of the slot unit is extracted. And then according to information of different slot units, slot unit spacing, and beam pointing control code, the transmission matrix is cascaded to simulate the total transmission characteristic (Ta) of the beam pointing adjustable antenna. The present disclosure then calculates an input ratio a₁ₙ of an input end 1, an input ratio a₂ₙ of an output end 2 under a two-port equivalent network of the n^{th} slot unit and under a single-port and single-unit excitation. The present disclosure then directly measure the directional pattern data based on the left end and right end of various slot units that are separately excited, on and off states of each slot unit (Enₗ for left-end excitation includes Enₗ₁ and Enₗ₀, and Enᵣ for right-end excitation includes Enᵣ₁ and Enᵣ₀).

Therefore, operability is strong or high, and directional pattern of the beam pointing adjustable antenna is calculated without depending on simulation software. In addition, the weighted calculation of directional pattern of the beam pointing adjustable antenna is realized. Key information including a form of the slot unit and arrangement and combination mode of the slot units can be globally optimized. Which greatly saves the optimization of slot unit selection, arrangement, combination, and spacing during antenna design, so as to focus on structural form of the slot unit. In addition, according to the beam pointing and deflection requirement, the corresponding beam pointing control codes for on and off states of each slot unit may be further calculated, so as to provide guidance for the regulation of the beam pointing and achieve fast beam shaping and switching.

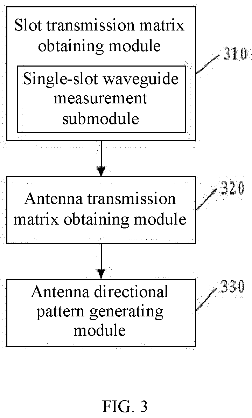

As shown in FIG. 3, according to an embodiment of the present disclosure, a device for calculating directional pattern of the beam pointing adjustable antenna is further provided, the device includes the following sequentially connected modules:
a slot transmission matrix obtaining module 310, configured for: obtaining a scattering parameter matrix of a single-slot waveguide corresponding to a single slot unit and a transmission matrix of a seamless waveguide through measurement, and obtaining an equivalent transmission matrix of the single slot unit according to a total transmission matrix of the single-slot waveguide and the transmission matrix of the seamless waveguide;
an antenna transmission matrix obtaining module 320, configured for: obtaining an arrangement and combination mode of the slot units and a beam pointing control code representing on or off state of each slot unit, and obtaining a transmission matrix cascading mode of the beam pointing adjustable antenna according to the arrangement and combination mode, the beam pointing control code, and an equivalent scattering parameter matrix of the single slot unit; and
an antenna directional pattern generating module 330, configured for: obtaining the directional pattern of the single-slot waveguide excited at the left end and the directional pattern of the single-slot waveguide excited at the right end, and obtaining a composite directional pattern of the beam pointing adjustable antenna according to the directional pattern of the single-slot waveguide excited at the left end, the directional pattern of the single-slot waveguide excited at the right end, and the transmission matrix cascading mode of the beam pointing adjustable antenna.

In one embodiment, the slot transmission matrix obtaining module 310 includes: a single-slot waveguide measurement submodule 312, configured for: performing a two-port test on the single-slot waveguide to obtain the scattering parameter matrix of the single-slot waveguide.

In one embodiment, the slot transmission matrix obtaining module 310 includes the following sequentially connected submodules: a seamless waveguide transmission model obtaining submodule (not shown) configured for: obtaining an equivalent transmission line model of the seamless waveguide; and a seamless waveguide transmission matrix obtaining submodule (not shown) configured for: performing calculation according to the equivalent transmission line model of the seamless waveguide and transmission line matrix theory, to obtain the transmission matrix of the seamless waveguide.

In an embodiment, the antenna directional pattern generating module 330 includes the following sequentially connected submodules: a slot unit equivalent input-output ratio obtaining submodule configured for: obtaining an equivalent input-to-output ratio of a single slot unit according to a transmission matrix of the beam pointing adjustable antenna; a single-slot waveguide directional pattern obtaining submodule configured for: obtaining the directional pattern of the single-slot waveguide excited at the left end and the directional pattern of the single-slot waveguide excited at the right end; and an antenna directional pattern generating submodule configured for: obtaining the composite directional pattern according to the directional pattern of the single-slot waveguide excited at the left end, the directional pattern of the single-slot waveguide excited at the right end, and the equivalent input-to-output ratio of the single slot unit.

In one embodiment, the beam pointing adjustable antenna is a one-dimensional or two-dimensional array structure.

## Claims

1. A method for calculating directional pattern of a leaky-wave antenna, the method is performed by a device for calculating directional pattern of a leaky-wave antenna, the device comprises a slot transmission matrix obtaining module (810), an antenna transmission matrix obtaining module (820) and an antenna directional pattern generating module (830) that are sequentially connected, the leaky-wave antenna comprising a plurality of slot units, the method comprising the following steps:
S1. obtaining, by the slot transmission matrix obtaining module, a total scattering parameter of a single-slot waveguide corresponding to a single slot unit and a transmission matrix of a seamless waveguide through measurement, and obtaining an equivalent transmission matrix of the single slot unit according to the total scattering parameter of the single-slot waveguide and the transmission matrix of the seamless waveguide (S101);
S2. obtaining, by the antenna transmission matrix obtaining module, an arrangement and combination mode of the slot units and a beam pointing control code representing on or off state of each slot unit, and simulating a transmission matrix Ta of the leaky-wave antenna in the form of a transmission matrix cascading mode according to the arrangement and combination mode and the beam pointing control code; and S3.
obtaining an equivalent input-to-output ratio of a single slot unit according to the transmission matrix Ta of the leaky-wave antenna;
obtaining the directional pattern of the single-slot waveguide excited at the left end and the directional pattern of the single-slot waveguide excited at the right end; and
obtaining the composite directional pattern according to the directional pattern of the single-slot waveguide excited at the left end, the directional pattern of the single-slot waveguide excited at the right end, and the equivalent input-to-output ratio of the single slot unit;
evaluating, according to the composite directional pattern of the leaky-wave antenna, electrical performance indicators of a leaky-wave antenna, wherein the electrical performance indicators comprise a beam pointing angle, main lobe 3dB beam width, a first null width, a side lobe level, a front-to-rear ratio

2. The method for calculating directional pattern of the leaky-wave antenna according to claim 1, wherein obtaining the total scattering parameter of the single-slot waveguide through measurement in step S1 comprises:
obtaining the total scattering parameter of the single-slot waveguide by performing a two-port test on the single-slot waveguide.

3. The method for calculating directional pattern of the leaky-wave antenna according to claim 1, wherein the arrangement and combination mode of the slot unit in step S2 comprises a spacing between the slot units, a form of the slot unit, or a combination of them.

4. The method for calculating directional pattern of the leaky-wave antenna according to claim 1, wherein obtaining the transmission matrix of the seamless waveguide in step S1 comprises:
obtaining an equivalent transmission line model of the seamless waveguide; and
performing calculation according to the equivalent transmission line model of the seamless waveguide and transmission line matrix theory to obtain the transmission matrix of the seamless waveguide.

5. The method for calculating directional pattern of the leaky-wave antenna according to claim 1, wherein the leaky-wave antenna is a one-dimensional or two-dimensional array structure.

6. A device for calculating directional pattern of the leaky-wave antenna, comprising:
a slot transmission matrix obtaining module (310) configured for: obtaining a total scattering parameter of a single-slot waveguide corresponding to a single slot unit and a transmission matrix of a seamless waveguide through measurement, and obtaining an equivalent transmission matrix of the single slot unit according to a total scattering parameter of the single-slot waveguide and the transmission matrix of the seamless waveguide;
an antenna transmission matrix obtaining module (320) configured for: obtaining an arrangement and combination mode of the slot units and a beam pointing control code representing on or off state of each slot unit, and simulating a transmission matrix Ta of the leaky-wave antenna in the form of a transmission matrix cascading mode according to the arrangement and combination mode and the beam pointing control code; and
an antenna directional pattern generating module (330), which comprises:
a slot unit equivalent input-output ratio obtaining submodule configured for: obtaining an equivalent input-to-output ratio of a single slot unit according to a transmission matrix Ta of the leaky-wave antenna;
a single-slot waveguide directional pattern obtaining submodule configured for: obtaining the directional pattern of the single-slot waveguide excited at the left end and the directional pattern of the single-slot waveguide excited at the right end; and
an antenna directional pattern generating submodule configured for: obtaining the composite directional pattern according to the directional pattern of the single-slot waveguide excited at the left end, the directional pattern of the single-slot waveguide excited at the right end, and the equivalent input-to-output ratio of the single slot unit;
wherein the slot unit equivalent input-output ratio obtaining submodule, the single-slot waveguide directional pattern obtaining submodule, and the antenna directional pattern generating submodule are sequentially connected;
wherein the slot transmission matrix obtaining module (310), the antenna transmission matrix obtaining module (320), and the antenna directional pattern generating module (330) are sequentially connected;
the device is further configured to evaluate, according to the composite directional pattern of the leaky-wave antenna, electrical performance indicators of a leaky-wave antenna, wherein the electrical performance indicators comprise a beam pointing angle, main lobe 3dB beam width, a first null width, a side lobe level, a front-to-rear ratio.

7. The device for calculating directional pattern of the leaky-wave antenna according to claim 6, wherein the slot transmission matrix obtaining module (310) comprises:
a single-slot waveguide measurement submodule (312), configured for: obtaining the total scattering parameter of the single-slot waveguide by performing a two-port test on the single-slot waveguide.

8. The device for calculating directional pattern of the leaky-wave antenna according to claim 7, wherein the slot transmission matrix obtaining module (310) comprises:
a seamless waveguide transmission model obtaining submodule configured for: obtaining an equivalent transmission line model of the seamless waveguide; and
a seamless waveguide transmission matrix obtaining submodule configured for: performing calculation according to the equivalent transmission line model of the seamless waveguide and transmission line matrix theory to obtain the transmission matrix of the seamless waveguide;
wherein the seamless waveguide transmission model obtaining submodule and the seamless waveguide transmission matrix obtaining submodule are sequentially connected.

## Patentansprüche

1. Verfahren zum Berechnen eines Richtungsmusters einer Leckwellenantenne, wobei das Verfahren durch eine Vorrichtung zum Berechnen eines Richtungsmusters einer Leckwellenantenne durchgeführt wird, wobei die Vorrichtung ein Schlitzübertragungsmatrix-Erhaltemodul (810), ein Antennenübertragungsmatrix-Erhaltemodul (820) und ein Antennenrichtungsmuster-Erzeugungsmodul (830) umfasst, die sequentiell verbunden sind, wobei die Leckwellenantenne mehrere Schlitzeinheiten umfasst, wobei das Verfahren die folgenden Schritte umfasst:
S1. Erhalten, durch das Schlitzübertragungsmatrix-Erhaltemodul, eines Gesamtstreuungsparameters eines Einzelschlitz-Wellenleiters, der einer Einzelschlitzeinheit entspricht, und einer Übertragungsmatrix eines nahtlosen Wellenleiters durch Messung, und Erhalten einer äquivalenten Übertragungsmatrix der Einzelschlitzeinheit gemäß dem Gesamtstreuungsparameter des Einzelschlitz-Wellenleiters und der Übertragungsmatrix des nahtlosen Wellenleiters (S101);
S2. Erhalten, durch das Antennenübertragungsmatrix-Erhaltemodul, eines Anordnungs- und Kombinationsmodus der Schlitzeinheiten und eines Strahlausrichtungssteuercodes, der einen Ein- oder Aus-Zustand jeder Schlitzeinheit darstellt, und Simulieren einer Übertragungsmatrix Ta der Leckwellenantenne in Form eines Übertragungsmatrix-Kaskadierungsmodus gemäß dem Anordnungs- und Kombinationsmodus und dem Strahlausrichtungssteuercode; und S3.
Erhalten eines äquivalenten Eingangs-Ausgangs-Verhältnisses einer Einzelschlitzeinheit gemäß der Übertragungsmatrix Ta der Leckwellenantenne;
Erhalten des Richtungsmusters des Einzelschlitz-Wellenleiters, das am linken Ende angeregt wird, und des Richtungsmusters des Einzelschlitz-Wellenleiters, das am rechten Ende angeregt wird; und
Erhalten des zusammengesetzten Richtungsmusters gemäß dem Richtungsmuster des Einzelschlitz-Wellenleiters, das am linken Ende angeregt wird, dem Richtungsmuster des Einzelschlitz-Wellenleiters, das am rechten Ende angeregt wird, und dem äquivalenten Eingangs-Ausgangs-Verhältnis der Einzelschlitzeinheit;
Bewerten, gemäß dem zusammengesetzten Richtungsmuster der Leckwellenantenne, von elektrischen Leistungsindikatoren einer Leckwellenantenne, wobei die elektrischen Leistungsindikatoren einen Strahlausrichtungswinkel, eine Hauptkeulen-3dB-Strahlbreite, eine erste Nullbreite, einen Seitenkeulenpegel, ein Verhältnis von vorne nach hinten umfassen.

2. Verfahren zum Berechnen eines Richtungsmusters der Leckwellenantenne nach Anspruch 1, wobei das Erhalten des Gesamtstreuungsparameters des Einzelschlitz-Wellenleiters durch Messung in Schritt S1 Folgendes umfasst:
Erhalten des Gesamtstreuungsparameters des Einzelschlitz-Wellenleiters durch Durchführen eines Zwei-Port-Tests an dem Einzelschlitz-Wellenleiter.

3. Verfahren zum Berechnen eines Richtungsmusters der Leckwellenantenne nach Anspruch 1, wobei der Anordnungs- und Kombinationsmodus der Schlitzeinheit in Schritt S2 einen Abstand zwischen den Schlitzeinheiten, eine Form der Schlitzeinheit oder eine Kombination davon umfasst.

4. Verfahren zum Berechnen eines Richtungsmusters der Leckwellenantenne nach Anspruch 1, wobei das Erhalten der Übertragungsmatrix des nahtlosen Wellenleiters in Schritt S1 Folgendes umfasst:
Erhalten eines äquivalenten Übertragungsleitungsmodells des nahtlosen Wellenleiters; und
Durchführen einer Berechnung gemäß dem äquivalenten Übertragungsleitungsmodell des nahtlosen Wellenleiters und der Übertragungsleitungsmatrixtheorie, um die Übertragungsmatrix des nahtlosen Wellenleiters zu erhalten.

5. Verfahren zum Berechnen eines Richtungsmusters der Leckwellenantenne nach Anspruch 1, wobei die Leckwellenantenne eine eindimensionale oder zweidimensionale Arraystruktur ist.

6. Vorrichtung zum Berechnen eines Richtungsmusters der Leckwellenantenne, umfassend:
ein Schlitzübertragungsmatrix-Erhaltemodul (310), das konfiguriert ist zum: Erhalten eines Gesamtstreuungsparameters eines Einzelschlitz-Wellenleiters, der einer Einzelschlitzeinheit entspricht, und einer Übertragungsmatrix eines nahtlosen Wellenleiters durch Messung, und Erhalten einer äquivalenten Übertragungsmatrix der Einzelschlitzeinheit gemäß einem Gesamtstreuungsparameter des Einzelschlitz-Wellenleiters und der Übertragungsmatrix des nahtlosen Wellenleiters;
ein Antennenübertragungsmatrix-Erhaltemodul (320), das konfiguriert ist zum: Erhalten eines Anordnungs- und Kombinationsmodus der Schlitzeinheiten und eines Strahlausrichtungssteuercodes, der einen Ein- oder Aus-Zustand jeder Schlitzeinheit darstellt, und Simulieren einer Übertragungsmatrix Ta der Leckwellenantenne in Form eines Übertragungsmatrix-Kaskadierungsmodus gemäß dem Anordnungs- und Kombinationsmodus und dem Strahlausrichtungssteuercode; und
ein Antennenrichtungsmuster-Erzeugungsmodul (330), das Folgendes umfasst:
ein Schlitzeinheit-äquivalentes Eingangs-Ausgangs-Verhältnis-Erhaltesubmodul, das konfiguriert ist zum: Erhalten eines äquivalenten Eingangs-Ausgangs-Verhältnisses einer Einzelschlitzeinheit gemäß einer Übertragungsmatrix Ta der Leckwellenantenne;
ein Einzelschlitz-Wellenleiter-Richtungsmuster-Erhaltesubmodul, das konfiguriert ist zum: Erhalten des Richtungsmusters des Einzelschlitz-Wellenleiters, das am linken Ende angeregt wird, und des Richtungsmusters des Einzelschlitz-Wellenleiters, das am rechten Ende angeregt wird; und
ein Antennenrichtungsmuster-Erzeugungssubmodul, das konfiguriert ist zum: Erhalten des zusammengesetzten Richtungsmusters gemäß dem Richtungsmuster des Einzelschlitz-Wellenleiters, das am linken Ende angeregt wird, dem Richtungsmuster des Einzelschlitz-Wellenleiters, das am rechten Ende angeregt wird, und dem äquivalenten Eingangs-Ausgangs-Verhältnis der Einzelschlitzeinheit;
wobei das Schlitzeinheit-äquivalentes Eingangs-Ausgangs-Verhältnis-Erhaltesubmodul, das Einzelschlitz-Wellenleiter-Richtungsmuster-Erhaltesubmodul und das Antennenrichtungsmuster-Erzeugungssubmodul sequentiell verbunden sind;
wobei das Schlitzübertragungsmatrix-Erhaltemodul (310), das Antennenübertragungsmatrix-Erhaltemodul (320) und das Antennenrichtungsmuster-Erzeugungsmodul (330) sequentiell verbunden sind;
die Vorrichtung ferner konfiguriert ist zum Bewerten, gemäß dem zusammengesetzten Richtungsmuster der Leckwellenantenne, von elektrischen Leistungsindikatoren einer Leckwellenantenne, wobei die elektrischen Leistungsindikatoren einen Strahlausrichtungswinkel, eine Hauptkeulen-3dB-Strahlbreite, eine erste Nullbreite, einen Seitenkeulenpegel, ein Verhältnis von vorne nach hinten umfassen.

7. Vorrichtung zum Berechnen eines Richtungsmusters der Leckwellenantenne nach Anspruch 6, wobei das Schlitzübertragungsmatrix-Erhaltemodul (310) Folgendes umfasst:
ein Einzelschlitz-Wellenleiter-Messsubmodul (312), das konfiguriert ist zum: Erhalten des Gesamtstreuungsparameters des Einzelschlitz-Wellenleiters durch Durchführen eines Zwei-Port-Tests an dem Einzelschlitz-Wellenleiter.

8. Vorrichtung zum Berechnen eines Richtungsmusters der Leckwellenantenne nach Anspruch 7, wobei das Schlitzübertragungsmatrix-Erhaltemodul (310) Folgendes umfasst:
ein Nahtloser-Wellenleiter-Übertragungsmodell-Erhaltesubmodul, das konfiguriert ist zum: Erhalten eines äquivalenten Übertragungsleitungsmodells des nahtlosen Wellenleiters; und
ein Nahtloser-Wellenleiter-Übertragungsmatrix-Erhaltesubmodul, das konfiguriert ist zum: Durchführen einer Berechnung gemäß dem äquivalenten Übertragungsleitungsmodell des nahtlosen Wellenleiters und der Übertragungsleitungsmatrixtheorie, um die Übertragungsmatrix des nahtlosen Wellenleiters zu erhalten;
wobei das Nahtloser-Wellenleiter-Übertragungsmodell-Erhaltesubmodul und das Nahtloser-Wellenleiter-Übertragungsmatrix-Erhaltesubmodul sequentiell verbunden sind.

## Revendications

1. Procédé de calcul de motif directionnel d'une antenne à ondes de fuite, le procédé est effectué par un dispositif de calcul de motif directionnel d'une antenne à ondes de fuite, le dispositif comprend un module d'obtention de matrice de transmission de fentes (810), un module d'obtention de matrice de transmission d'antenne (820) et un module de génération de motif directionnel d'antenne (830) qui sont connectés séquentiellement, l'antenne à ondes de fuite comprenant une pluralité d'unités à fente, le procédé comprenant les étapes suivantes :
Étape S1. obtenir, par le module d'obtention de matrice de transmission de fentes, un paramètre de diffusion totale d'un guide d'ondes à fente unique correspondant à une unité à fente unique et une matrice de transmission d'un guide d'ondes flexible par mesurage, et obtenir une matrice de transmission équivalente de l'unité à fente unique en fonction du paramètre de diffusion totale du guide d'ondes à fente unique et de la matrice de transmission du guide d'ondes flexible (S101) ;
Étape S2. obtenir, par le module d'obtention de matrice de transmission d'antenne, un agencement et un mode de combinaison des unités à fente et un code de commande de pointage de faisceau représentant un état de marche et d'arrêt de chaque unité à fente, et simuler une matrice de transmission Ta de l'antenne à ondes de fuite sous la forme d'un mode en cascade de matrice de transmission en fonction de l'agencement et du mode de combinaison et du code de commande de pointage de faisceau ; et
Étape S3. obtenir un rapport d'entrée-à-sortie équivalent d'une unité à fente unique en fonction de la matrice de transmission Ta de l'antenne à ondes de fuite ;
obtenir le motif directionnel du guide d'ondes à fente unique excité à l'extrémité gauche et le motif directionnel du guide d'ondes à fente unique excité à l'extrémité droite ; et
obtenir le motif directionnel composite en fonction du motif directionnel du guide d'ondes à fente unique excité à l'extrémité gauche, du motif directionnel du guide d'ondes à fente unique excité à l'extrémité droite et du rapport d'entrée-à-sortie équivalent de l'unité à fente unique ;
évaluer, en fonction du motif directionnel composite de l'antenne à ondes de fuite, des indicateurs de performance électrique d'une antenne à ondes de fuite, dans lequel les indicateurs de performance électrique comprennent un angle de pointage de faisceau, une largeur de faisceau 3dB de lobe principal, une première largeur nulle, un niveau du lobe latéral, un rapport d'avant en arrière.

2. Procédé de calcul de motif directionnel de l'antenne à ondes de fuite selon la revendication 1, dans lequel l'obtention du paramètre de diffusion totale du guide d'ondes à fente unique par le mesurage à l'étape S1 consiste à :
obtenir le paramètre de diffusion totale du guide d'ondes à fente unique en effectuant un test à deux ports sur le guide d'ondes à fente unique.

3. Procédé de calcul de motif directionnel de l'antenne à ondes de fuite selon la revendication 1, dans lequel l'agencement et le mode de combinaison de l'unité à fentes à l'étape S2 comprennent un espacement entre les unités à fente, une forme de l'unité à fente, ou une combinaison de celles-ci.

4. Procédé de calcul de motif directionnel de l'antenne à ondes de fuite selon la revendication 1, dans lequel l'obtention de la matrice de transmission du guide d'ondes flexible à l'étape S1 consiste à :
obtenir un modèle de ligne de transmission équivalente du guide d'ondes flexible ; et
effectuer un calcul en fonction du modèle de ligne de transmission équivalent du guide d'ondes flexible et de la théorie de matrice de ligne de transmission pour obtenir la matrice de transmission du guide d'ondes flexible.

5. Procédé de calcul de motif directionnel de l'antenne à ondes de fuite selon la revendication 1, dans lequel l'antenne à ondes de fuite est une structure de réseau unidimensionnel ou bidimensionnel.

6. Dispositif de calcul de motif directionnel de l'antenne à ondes de fuite, comprenant :
un module d'obtention de matrice de transmission de fentes (310) configuré pour : obtenir un paramètre de diffusion totale d'un guide d'ondes à fente unique correspondant à une unité à fente et une matrice de transmission d'un guide d'ondes flexible par mesurage, et obtenir une matrice de transmission équivalente de l'unité à fente unique en fonction d'un paramètre de diffusion totale du guide d'ondes à fente unique et de la matrice de transmission du guide d'ondes flexible ;
un module d'obtention de matrice de transmission d'antenne (320) configuré pour : obtenir un agencement et un mode de combinaison des unités à fente et un code de commande de pointage de faisceau représentant un état de marche et d'arrêt de chaque unité à fente, et simuler une matrice de transmission Ta de l'antenne à ondes de fuite sous la forme d'un mode en cascade de matrice de transmission en fonction de l'agencement et du mode de combinaison et du code de commande de pointage de faisceau ; et
un module de génération de motif directionnel d'antenne (330), qui comprend :
un sous-module d'obtention d'un rapport d'entrée à sortie équivalent configuré pour : obtenir un rapport d'entrée-à-sortie équivalent une unité à fente unique en fonction d'une matrice de transmission Ta de l'antenne à ondes de fuite ;
un sous-module d'obtention de motif directionnel du guide d'ondes à fente unique configuré pour : obtenir le motif directionnel du guide d'ondes à fente unique excité à l'extrémité gauche et le motif directionnel du guide d'ondes à fente unique excité à l'extrémité droite ; et
un sous-module de génération de motif directionnel d'une antenne configuré pour : obtenir le motif directionnel composite en fonction du motif directionnel du guide d'ondes à fente unique excité à l'extrémité gauche, du motif directionnel du guide d'ondes à fente unique excité à l'extrémité droite et du rapport d'entrée-à-sortie équivalent de l'unité à fente unique ;
dans lequel le sous-module d'obtention d'un rapport d'entrée à sortie équivalent, le sous-module d'obtention de motif directionnel de guide d'ondes à fente unique et le sous-module de génération de motif directionnel d'une antenne sont connectés séquentiellement ;
dans lequel le module d'obtention de matrice de transmission de fentes (310), le module d'obtention de matrice de transmission d'antenne (320) et le module de génération de motif directionnel d'antenne (330) sont connectés séquentiellement ;
le dispositif est configuré en outre pour évaluer, en fonction du motif directionnel composite de l'antenne à ondes de fuite, des indicateurs de performance électrique d'une antenne à ondes de fuite, dans lequel les indicateurs de performance électrique comprennent un angle de pointage de faisceau, une largeur de faisceau 3dB de lobe principal, une première largeur nulle, un niveau du lobe latéral, un rapport d'avant en arrière.

7. Dispositif de calcul de motif directionnel de l'antenne à ondes de fuite selon la revendication 6, dans lequel le module d'obtention de matrice de transmission de fentes (310) comprend :
un sous-module de mesure de guide d'ondes à fente unique (312), configuré pour : obtenir le paramètre de diffusion totale du guide d'ondes à fente unique en effectuant un test à deux ports sur le guide d'ondes à fente unique.

8. Dispositif de calcul d'un motif directionnel de l'antenne à ondes de fuite selon la revendication 7, dans lequel le module d'obtention de matrice de transmission de fentes (310) comprend :
un sous-module d'obtention de matrice de transmission de guide d'ondes flexible configuré pour : obtenir un modèle de ligne de transmission équivalent du guide d'ondes flexible ; et
un sous-module d'obtention de matrice de transmission de guide d'ondes flexible configuré pour : effectuer un calcul en fonction du modèle de ligne de transmission équivalent du guide d'ondes flexible et de la théorie de matrice de ligne de transmission pour obtenir la matrice de transmission du guide d'ondes flexible ;
dans lequel le sous-module d'obtention de modèle de matrice de transmission de guide d'ondes flexible et le sous-module d'obtention de matrice de transmission de guide d'ondes flexible sont connectés séquentiellement.
